# EUROPÄISCHE PATENTSCHRIFT

(11) **EP 1 831 647 B1**
(45) Veröffentlichungstag und Bekanntmachung des Hinweises auf die Patenterteilung: **24.05.2017**
(21) Anmeldenummer: 05816210.8
(22) Anmeldetag: 02.12.2005
(51) Int. Cl.: G01D 11/26, F16J 15/06, B60K 35/00, H05K 5/06

(54) **ANZEIGEINSTRUMENT UND VERFAHREN ZUM HERSTELLEN UND ZUM DEMONTIEREN EINES ANZEIGEINSTRUMENTES**
DISPLAY INSTRUMENT AND METHOD FOR PRODUCTION AND DISASSEMBLY OF A DISPLAY INSTRUMENT
INDICATEUR ET PROCEDE POUR REALISER ET DEMONTER UN INDICATEUR

(30) Priorität: 27.12.2004 DE 102004062880
(43) Veröffentlichungstag der Anmeldung: 12.09.2007
(73) Patentinhaber: Continental Automotive GmbH, 30165 Hannover (DE)
(72) Erfinder: ADAMS, Jürgen, 78052 Villingen-Schwenningen (DE)
(86) Internationale Anmeldenummer: PCT/EP2005/056437
(87) Internationale Veröffentlichungsnummer: WO 2006/069889

(56) Entgegenhaltungen:
- DE-A1- 2 133 777
- DE-A1- 4 318 011
- US-A- 4 306 652
- BOCK T: "LOW COMPRESSION LOAD HOUSING SEAL" MOTOROLA TECHNICAL DEVELOPMENTS, MOTOROLA INC. SCHAUMBURG, ILLINOIS, US, Bd. 17, 1. Dezember 1992 (1992-12-01), Seiten 152-153, XP000329527 ISSN: 0887-5286

## Beschreibung

Die Erfindung bezieht sich auf ein Anzeigeinstrument, insbesondere für ein Kraftfahrzeug, mit einem eine Deckscheibe halternden Gehäuse und einem das Gehäuse und die Deckscheibe verbindenden, in eine in dem Gehäuse angeordnete Gehäuseausnehmung eingreifenden Verbindungselement. Außerdem bezieht sich die Erfindung auf ein Verfahren zum Herstellen eines Anzeigeinstrumentes, insbesondere für ein Kraftfahrzeug, wobei eine Deckscheibe mit einem Gehäuse verbunden wird sowie auf ein Verfahren zum Demontieren eines Anzeigeinstrumentes, insbesondere für ein Kraftfahrzeug, wobei eine Deckscheibe von einem Gehäuse getrennt wird.

Allgemein ist ein vorgenanntes Anzeigeinstrument als Kombinationsanzeigeinstrument für Kraftfahrzeuge bekannt. Es weist ein Gehäuse auf, das analoge und/oder digitale Anzeigen beherbergt, die für einen Betrachter, üblicherweise zumindest der Fahrzeugführer, durch eine plane oder gewölbte Deckscheibe hindurch sichtbar sind. Im üblichen Sprachgebrauch wird die Deckscheibe auch als Deckglas bezeichnet, obwohl der Werkstoff dieses Deckbauteils nicht auf Glas beschränkt und regelmäßig ein Kunststoff ist. Um eine feste und dichte Verbindung zwischen Deckscheibe und Gehäuse herzustellen, sind Deckscheibe und Gehäuse miteinander verschweißt, zum Beispiel mittels Reib- oder Ultraschallverschweißung, oder verklebt.

Ferner ist ein Anzeigeinstrument für Kraftfahrzeuge bekannt, das ein Gehäuse mit einem eine Deckscheibe halternden Frontrahmen und einem zwischen Deckscheibe und Frontrahmen angeordneten Abstandselement als ein Verbindungselement aufweist. Das Abstandselement ist in einer in einem Umfangsbereich des Frontrahmens angeordneten und der Deckscheibe zugewandten A-xialausnehmung plaziert, in die die Deckscheibe eingreifbar ist. Eine Halterung der Deckscheibe an dem Frontrahmen und damit dem Gehäuse erfolgt durch eine Verklebung von Abstandselement, Deckscheibe und Frontrahmen oder durch eine das Abstandselement übergreifende Verklipsung von Deckscheibe und Frontrahmen.

Ein beschädigungsfreies Lösen mit nachfolgendem erneuten Zusammenbau ist bei beiden vorbeschriebenen Anzeigeinstrumenten nicht möglich.

Andere Lösungen für eine Verbindung einer Scheibe mit einem Rahmen oder einem Gehäuse, welche Lösungen Profilelemente verwenden, die mit Hilfe eines Einfädelmittels übergestülpt werden und die Scheibe umschließen, sind insbesondere für Anzeigeinstrumente in Kraftfahrzeugen weniger geeignet, da sie einen hohen Platzbedarf haben.

Aus der DE 2 133 777 A1 ist ein eine Dichtung aufweisendes Gehäuse für elektrische und mechanische Geräte bekannt. Die Publikation "Low Compression Load Housing Seal" offenbart eine zwischen einer oberen und einer unteren Gehäusehälfte angeordnete Dichtung. Die US 4,306,652 zeigt ein Anzeigegerät gemäß Oberbegriff des Anspruchs 1.

Aufgabe der Erfindung ist es zum einen, ein Anzeigeinstrument der eingangs genannten Art zu schaffen, das eine sichere, lösbare und wiederherstellbare Verbindung von Deckscheibe und Gehäuse aufweist. Zum anderen liegt der Erfindung die Aufgabe zugrunde, ein Verfahren der eingangs genannten Art zum Herstellen eines Anzeigeinstrumentes anzugeben, das eine vorgenannte Verbindung aufweist. Ferner ist es auch Aufgabe der Erfindung, ein Verfahren der eingangs genannten Art zum Demontieren eines Anzeigeinstrumentes mit einer vorgenannten Verbindung anzugeben.

Die erstgenannte Aufgabe wird erfindungsgemäß durch die im kennzeichnenden Teil des Anspruchs 1 angegebenen Merkmale gelöst.

Auf diese Weise kann eine dichte Verbindung von Gehäuse und Deckscheibe gewährleistet werden, so daß das Innere des Anzeigeinstrumentes vor Umwelteinflüssen, insbesondere Staub und Feuchtigkeit, geschützt ist. Das erfindungsgemäße Anzeigeinstrument ist dadurch sehr betriebssicher und weist eine hohe Dauerhaltbarkeit auf. Besonders vorteilhaft ist, daß mit der Erfindung die Möglichkeit einer zuverlässigen kraftschlüssigen Verbindung von Gehäuse und Deckscheibe gegeben ist, es ist nicht erforderlich eine form- oder stoffschlüssige Verbindung vorzusehen. Außerdem ist es einfach möglich, Gehäuse und Deckscheibe, die plan oder gewölbt sein kann, voneinander zu trennen; hierfür ist lediglich eine Überwindung der Vorspannung des Verbindungselementes erforderlich. Eine Beschädigung von Gehäuse und/oder Deckscheibe ist entbehrlich, und ein nachträglicher erneuter Zusammenbau kann vorgenommen werden. Das erweist sich insbesondere dann als Vorteil, wenn die Deckscheibe des Anzeigeinstrumentes beschädigt, vor allem zerkratzt, ist und ausgetauscht werden soll. Im Gegensatz zu den bekannten Lösungen, die in einem solchen Fall nachteilig einen Ausbau des gesamten Anzeigeinstrumentes, zum Beispiel aus einem Kraftfahrzeug, erfordern, ist es mit der Erfindung möglich, die Deckscheibe ohne Beschädigung und/oder Ausbau des Gehäuses und ohne Trennung insbesondere elektrischer Verbindungen von dem Anzeigeinstrument zu entnehmen und eine neue Deckscheibe einzusetzen. Durch die Vorspannung und die damit einhergehende Klemmwirkung des Verbindungselementes wird in einer Doppelfunktion einerseits eine zuverlässige Abdichtung der Deckscheibe und andererseits ein sicherer Halt der Deckscheibe an dem Gehäuse sichergestellt. Bei dem erfindungsgemäßen Anzeigeinstrument sind somit weder zur Abdichtung noch zur Halterung der Deckscheibe neben dem Verbindungselement weitere (Bau-)Elemente wie beispielsweise Klipse oder Klebenähte erforderlich. Vorzugsweise sitzt das Verbindungselement sowohl in der Gehäuseausnehmung als auch in der Scheibenausnehmung mit einer leichten Quetschpassung.

Gemäß der Erfindung weist das Gehäuse eine die Gehäuseausnehmung mit einer der Deckscheibe abgewandten Gehäuseoberfläche verbindende Entlüftungsdurchbrechung und/oder die Deckscheibe eine die Scheibenausnehmung mit einer dem Gehäuse abgewandten Scheibenoberfläche verbindende Entlüftungsdurchbrechung auf. So kann einerseits verhindert werden, daß ein in der Ausnehmung von dem Verbindungselement eingeschlossenes Luftvolumen den Sitz des Verbindungselementes behindert, und andererseits kann beispielsweise durch Evakuierung oder Entlüftung der Ausnehmung durch die Entlüftungsdurchbrechung das Verbindungselement in die jeweilige Ausnehmung eingesaugt werden.

Gemäß einer vorteilhaften Weiterbildung der Erfindung ist die Gehäuseausnehmung als eine einen U-förmigen Querschnitt aufweisende Gehäusenut und/oder die Scheibenausnehmung als eine einen U-förmigen Querschnitt aufweisende Scheibennut ausgebildet. Auf diese Weise lassen sich die Ausnehmungen ohne eine Erhöhung des Fertigungsaufwandes insbesondere dann einfach herstellen, wenn die Deckscheibe und/oder das Gehäuse ein Kunststoffspritzgußteil ist.

Man könnte sich vorstellen, daß nur in bestimmten Bereichen und abschnittweise Ausnehmungen in Gehäuse und/oder Deckscheibe angeordnet sind. Demgegenüber läßt sich das Verbindungselement vereinfacht in die Ausnehmungen einbringen, wenn gemäß einer anderen vorteilhaften Weiterbildung der Erfindung die Gehäuseausnehmung umlaufend in einem Randbereich des Gehäuses und/oder die Scheibenausnehmung umlaufend in einem Randbereich der Deckscheibe angeordnet ist. Vorzugsweise sind sowohl Scheibenausnehmung als auch Gehäuseausnehmung umlaufend ausgebildet, und das Verbindungselement ist in den Ausnehmungen über deren gesamte Länge angeordnet. Dadurch wird eine sehr hohe Dichtigkeit des Anzeigeinstrumentes gewährleistet.

Grundsätzlich können die Scheibenausnehmung und die Gehäuseausnehmung beispielsweise in etwa parallel zu einer von der Deckscheibe angegebenen Ebene ausgerichtet sein. Eine besonders einfache Montage und Demontage des Anzeigeinstrumentes wird hingegen dadurch erreicht, daß gemäß einer anderen vorteilhaften Weiterbildung der Erfindung die Gehäuseausnehmung und die Scheibenausnehmung parallel zu einer Fügerichtung von Gehäuse und Deckscheibe ausgerichtete Axialausnehmungen sind.

Die Sicherheit der Abdichtung des Anzeigeinstrumentes sowie die Dauerhaltbarkeit der Verbindung von Deckscheibe und Gehäuse wird vorteilhaft dadurch erhöht, daß gemäß einer anderen Weiterbildung der Erfindung das Verbindungselement einen dauerelastischen Werkstoff aufweist. Vorzugsweise wird das Verbindungselement von einem Gummi- oder Silikonring gebildet.

Auch bei auf dem Grund der Gehäuse- und/oder Scheibenausnehmung aufliegendem Verbindungselement kann eine weitere Entlüftung, insbesondere zu einer Entlüftungsdurchbrechung, erfolgen, wenn gemäß einer vorteilhaften Weiterbildung der Erfindung an einem Grund der Gehäuseausnehmung und/oder an einem Grund der Scheibenausnehmung ein Entlüftungskanal angeordnet ist. Dadurch kann vermieden werden, daß das - gegebenenfalls elastische - Verbindungselement einen Abschnitt der Ausnehmung vorzeitig abdichtet und damit eine gleichmäßige Anordnung des Verbindungselementes in der Ausnehmung gestört wird.

Der Einbau des Verbindungselementes kann dadurch erheblich vereinfacht werden, daß gemäß einer anderen vorteilhaften Weiterbildung der Erfindung die Gehäuseausnehmung an ihrem Übergang zur Gehäuseoberfläche und/oder die Scheibenausnehmung an ihrem Übergang zur Scheibenoberfläche eine Aufweitung aufweist.

Die oben zweitgenannte Aufgabe wird erfindungsgemäß gelöst mit einem Verfahren, bei dem nacheinander zumindest ein erster Teilbereich eines Verbindungselementes in eine Gehäuseausnehmung des Gehäuses unter Vorspannung eingefügt wird, die Deckscheibe und das Gehäuse aneinander gelegt werden, ein zweiter Teilbereich des Verbindungselementes in eine mit der Gehäuseausnehmung korrespondierende Scheibenausnehmung der Deckscheibe das Gehäuse und die Deckscheibe miteinander verbindend unter Vorspannung eingefügt wird. Dabei wird das Verbindungselement in die Gehäuseausnehmung und/oder in die Scheibenausnehmung eingesaugt. Die vorgenannte Aufgabe wird auch gelöst mit einem Verfahren, bei dem nacheinander zumindest ein erster Teilbereich eines Verbindungselementes in eine Scheibenausnehmung der Deckscheibe unter Vorspannung eingefügt wird, die Deckscheibe und das Gehäuse aneinander gelegt werden, ein zweiter Teilbereich des Verbindungselementes in eine mit der Scheibenausnehmung korrespondierende Gehäuseausnehmung des Gehäuses die Deckscheibe und das Gehäuse miteinander verbindend unter Vorspannung eingefügt wird. Auch hierbei wird das Verbindungselement in die Gehäuseausnehmung und/oder in die Scheibenausnehmung eingesaugt.

Beide vorgenannten Verfahren, die sich in der Abfolge der Verfahrensschritte unterscheiden, ermöglichen in sehr einfacher Weise ohne aufwendige Fertigungsvorrichtungen und kostengünstig einen Zusammenbau eines Anzeigeinstrumentes. Die Verfahren sind besonders geeignet zum Herstellen eines oben beschriebenen, erfindungsgemäßen Anzeigeinstrumentes.

Man könnte sich beispielsweise vorstellen, daß das Verbindungselement bei einem Zusammenschieben von Gehäuse und Deckscheibe mittels dabei aufgebrachten direkten, mechanischen Druckes in die Ausnehmungen eingequetscht wird. Hingegen ist die Gefahr einer Beschädigung des Verbindungselementes besonders gering, wenn gemäß der Erfindung das Verbindungselement in die Gehäuseausnehmung und/oder in die Scheibenausnehmung eingesaugt wird. Das Einsaugen kann vorzugsweise durch ein Absaugen von Luft aus der oder den Ausnehmungen erfolgen, beispielsweise durch Anlegen eines Unterdruckes. Dabei kann sich das Verbindungselement beim Einsaugen in die Ausnehmung verformen, so daß eine Verschlankung seines Querschnittes mit der Folge eines Aufbaus mechanischer Druckspannung eintritt. Der Endsitz des Verbindungselementes kann vorteilhaft dann erreicht sein, wenn das Verbindungselement an einem Grund der jeweiligen Ausnehmung zur Anlage kommt.

Die oben drittgenannte Aufgabe wird erfindungsgemäß dadurch gelöst, daß ein in einer Scheibenausnehmung der Deckscheibe und einer Gehäuseausnehmung des Gehäuses unter Vorspannung angeordnetes Verbindungselement aus der Scheibenausnehmung oder aus der Gehäuseausnehmung eine Trennung von Gehäuse und Deckscheibe herbeiführend herausgedrückt wird.

Das Herausdrücken erfolgt mittels Druckluft. Ansätze, Haken, Ausnehmungen oder ähnliche Elemente an der Deckscheibe sind mit der Erfindung nicht erforderlich, ein direkter Angriff an der Deckscheibe oder dem Gehäuse ist beim Demontieren des Anzeigeinstrumentes nicht erforderlich. Das Verfahren eignet sich insbesondere zum Demontieren eines oben beschriebenen, erfindungsgemäßen Anzeigeinstrumentes.

Ein Ausführungsbeispiel der Erfindung ist in der Zeichnung schematisiert dargestellt und wird im folgenden näher beschrieben. Es zeigen
- Figur 1: eine Schnittansicht eines Anzeigeinstrumentes,
- Figur 2: ein vergrößertes Detail des Anzeigeinstrumentes nach Figur 1,
- Figur 3: ein anderes Detail des Anzeigeinstrumentes nach Figur 1 mit einem Montagewerkzeug und
- Figur 4: ein weiteres Detail des Anzeigeinstrumentes nach Figur 1 mit einem Demontagewerkzeug.

Sich jeweils entsprechende Elemente sind in den verschiedenen Figuren mit gleichen Bezugszeichen versehen.

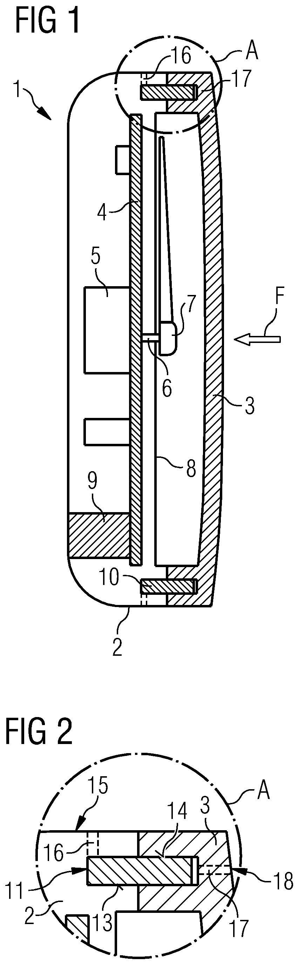

Figur 1 zeigt in einer Schnittansicht ein Anzeigeinstrument 1 eines Kraftfahrzeuges mit einem Gehäuse 2 und einer das Gehäuse 2 zu einem Betrachter hin abdeckenden, gewölbten Deckscheibe 3 aus einem transparenten Kunststoff, beispielsweise PMMA (Polymethylmethacrylat). Die Deckscheibe 3 ist beispielsweise für Wartungszwecke oder zu ihrem Austausch auswechselbar am Gehäuse 2 angebracht. In dem Gehäuse 2 ist eine Leiterplatte 4 angeordnet, die verschiedene elektrische und elektronische Bauteile trägt, unter anderem einen Zeigerantrieb 5, mittels dessen über eine Zeigerwelle 6 ein Zeiger 7 bewegbar ist.

Dem Zeiger 7 ist eine Skala auf einem Zifferblatt 8 zur Anzeige von zum Beispiel einer Fahrgeschwindigkeit oder Motordrehzahl des Kraftfahrzeuges zugeordnet. Für eine elektrische Kontaktierung der Leiterplatte 4 weist diese auf ihrer Rückseite einen Gerätestecker 9 auf.

Die Deckscheibe 3 ist an dem Gehäuse 2 mittels eines einen rechteckigen Querschnitt aufweisenden, elastischen Verbindungselementes 10, vorzugsweise ein Gummiring, gehalten. In Zusammenhang mit Figur 2, die eine vergrößerte Ansicht eines Details A aus Figur 1 zeigt, wird deutlich, daß das Verbindungselement 10 sowohl in eine in dem Gehäuse 2 angeordnete Gehäuseausnehmung 11 als auch in eine mit der Gehäuseausnehmung 11 korrespondierende, in der Deckscheibe 3 angeordnete Scheibenausnehmung 12 eingreift. Die Gehäuseausnehmung 11 ist als einen U-förmigen Querschnitt aufweisende Gehäusenut 13 und die Scheibenausnehmung 12 als einen U-förmigen Querschnitt aufweisende Scheibennut 14 ausgebildet.

Die Gehäusenut 13 und die Scheibennut 14 sind umlaufend in einem Randbereich des Gehäuses 2 beziehungsweise der Deckscheibe 3 angeordnet (vgl. Figur 1). Sowohl in der Gehäusenut 13 als auch in der Scheibennut 14 ist das Verbindungselement 10 unter Vorspannung angeordnet. Bei der Gehäusenut 13 und der Scheibennut 14 handelt es sich um Axialausnehmungen, die parallel zu einer durch eine Pfeil F symbolisierten Fügerichtung von Gehäuse 2 und Deckscheibe 3 ausgerichtet sind.

Das Gehäuse 2 weist eine die Gehäuseausnehmung 11 mit einer Gehäuseoberfläche 15, die der Deckscheibe 3 abgewandt ist, also nach außen weist, verbindende Entlüftungsdurchbrechung 16 auf. Eine weitere Entlüftungsdurchbrechung 17 ist in der Deckscheibe 3 vorgesehen, und zwar so, daß die Entlüftungsdurchbrechung 17 die Scheibenausnehmung 12 mit einer dem Gehäuse 2 abgewandten, also nach außen weisenden, Scheibenoberfläche 18 verbindet.

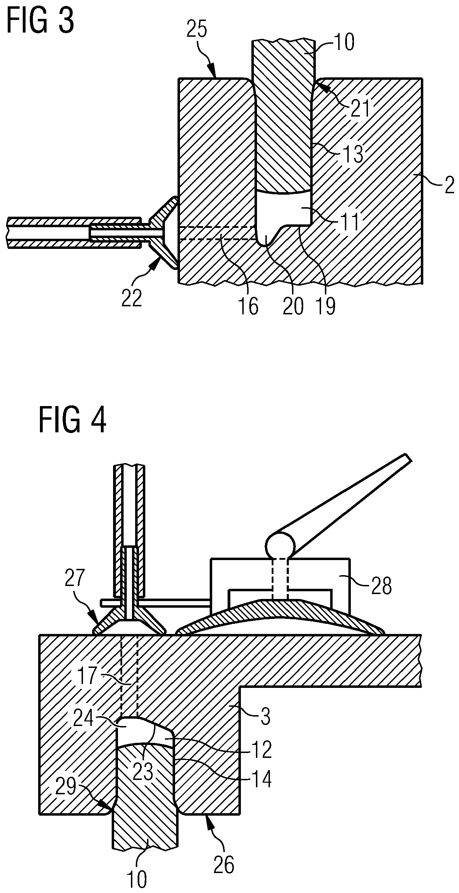

Ein Abschnitt des Gehäuses 2 mit dem in der Gehäusenut 13 angeordneten Verbindungselement 10 ist in einer Detailansicht in Figur 3 gezeigt. Die Gehäusenut 13 weist an ihrem Übergang zu einer der Deckscheibe zugewandten Gehäuseoberfläche 25 eine Aufweitung 21 auf und ist an ihrem Nutgrund 19 mit einem Entlüftungskanal 20 versehen. An den Entlüftungskanal 20 ist die Entlüftungsdurchbrechung 16 des Gehäuses 2 angeschlossen. Ein als Saugadapter mit einem Schlauch zu einer Vakuumquelle ausgebildetes, vor die Entlüftungsdurchbrechung 16 gesetztes Montagewerkzeug 22 dient einer Entlüftung der Gehäuseausnehmung 11, wodurch das Verbindungselement 10 in die Gehäusenut 13 einsaugbar ist.

In Figur 4 ist in einer Detailansicht ein Abschnitt der Deckscheibe 3 mit dem in der Scheibennut 14 angeordneten Verbindungselement 10 gezeigt. Die Scheibennut 14 besitzt an ihrem Nutgrund 23 einen Entlüftungskanal 24, an den die Entlüftungsdurchbrechung 17 angeschlossen ist. Ferner weist die Scheibennut 14 an ihrem Übergang zu einer dem Gehäuse zugewandten Scheibenoberfläche 26 eine Aufweitung 29 auf. Vor die Entlüftungsdurchbrechung 17 ist ein erstes Demontagewerkzeug 27 gesetzt, das als Saug- und Einblasadapter mit Schlauch zu einer Vakuumquelle und einer Druckluftquelle ausgebildet ist, so daß das Verbindungselement 10 durch Einbringen von Druckluft in die Scheibenausnehmung 12 aus der Scheibennut 14 herausdrückbar ist. Das erste Demontagewerkzeug 27 ist mit einem zweiten Demontagewerkzeug 28 verbunden, das als Saug-Haftelement zur Abstützung des ersten Demontagewerkzeuges 27 sowie zur Entnahme der Deckscheibe 3 ausgebildet ist. Montage und Demontage der Deckscheibe 3 können im eingebauten Zustand des Anzeigeinstrumentes in dem Kraftfahrzeug vorgenommen werden.

## Patentansprüche

1. Anzeigeinstrument mit einer Deckscheibe, einem die Deckscheibe (3) halternden Gehäuse (2) und einem das Gehäuse (2) und die Deckscheibe (3) verbindenden, in eine in dem Gehäuse (2) angeordnete Gehäuseausnehmung (11) eingreifenden Verbindungselement (10), wobei das Verbindungselement (10) in der Gehäuseausnehmung (11) und in einer mit der Gehäuseausnehmung (11) korrespondierenden Scheibenausnehmung (12) der Deckscheibe (3) unter Vorspannung angeordnet ist, **dadurch gekennzeichnet, daß** das Gehäuse (2) eine die Gehäuseausnehmung (11) mit einer der Deckscheibe (3) abgewandten Gehäuseoberfläche (15) verbindende Entlüftungsdurchbrechung (16) und/oder die Deckscheibe (3) eine die Scheibenausnehmung (12) mit einer dem Gehäuse (2) abgewandten Scheibenoberfläche (18) verbindende Entlüftungsdurchbrechung (17) aufweist.

2. Anzeigeinstrument nach Anspruch 1, **dadurch gekennzeichnet, daß** die Gehäuseausnehmung (11) als eine einen U-förmigen Querschnitt aufweisende Gehäusenut (13) und/oder die Scheibenausnehmung (12) als eine einen U-förmigen Querschnitt aufweisende Scheibennut (14) ausgebildet ist.

3. Anzeigeinstrument nach einem der Ansprüche 1 und 2, **dadurch gekennzeichnet, daß** die Gehäuseausnehmung (11) umlaufend in einem Randbereich des Gehäuses (2) und/oder die Scheibenausnehmung (12) umlaufend in einem Randbereich der Deckscheibe (3) angeordnet ist.

4. Anzeigeinstrument nach einem der vorhergehenden Ansprüche, **dadurch gekennzeichnet, daß** die Gehäuseausnehmung (11) und die Scheibenausnehmung (12) parallel zu einer Fügerichtung von Gehäuse (2) und Deckscheibe (3) ausgerichtete Axialausnehmungen sind.

5. Anzeigeinstrument nach einem der vorhergehenden Ansprüche, **dadurch gekennzeichnet, daß** das Verbindungselement (10) einen dauerelastischen Werkstoff aufweist.

6. Anzeigeinstrument nach einem der vorhergehenden Ansprüche, **dadurch gekennzeichnet, daß** an einem Grund der Gehäuseausnehmung (11) und/oder an einem Grund der Scheibenausnehmung (12) ein Entlüftungskanal (20, 24) angeordnet ist.

7. Anzeigeinstrument nach einem der vorhergehenden Ansprüche, **dadurch gekennzeichnet, daß** die Gehäuseausnehmung (11) an ihrem Übergang zur Gehäuseoberfläche (25) und/oder die Scheibenausnehmung (12) an ihrem Übergang zur Scheibenoberfläche (26) eine Aufweitung (21, 29) aufweist.

8. Verfahren zum Herstellen eines Anzeigeinstrumentes nach Anspruch 1, wobei eine Deckscheibe (3) mit einem Gehäuse (2) verbunden wird und wobei nacheinander zumindest ein erster Teilbereich eines Verbindungselementes (10) in eine Gehäuseausnehmung (11) des Gehäuses (2) unter Vorspannung eingefügt wird, die Deckscheibe (3) und das Gehäuse (2) aneinander gelegt werden, ein zweiter Teilbereich des Verbindungselementes (10) in eine mit der Gehäuseausnehmung (11) korrespondierende Scheibenausnehmung (12) der Deckscheibe (3) das Gehäuse (2) und die Deckscheibe (3) miteinander verbindend unter Vorspannung eingefügt wird, **dadurch gekennzeichnet, daß** das Verbindungselement (10) in die Gehäuseausnehmung (11) und/oder in die Scheibenausnehmung (12) eingesaugt wird.

9. Verfahren nach Anspruch 8, **dadurch gekennzeichnet, daß** zunächst zumindest ein erster Teilbereich eines Verbindungselementes (10) in eine Scheibenausnehmung (12) der Deckscheibe (3) unter Vorspannung eingefügt wird, dann die Deckscheibe (3) und das Gehäuse (2) aneinander gelegt werden, und danach ein zweiter Teilbereich des Verbindungselementes (10) in eine mit der Scheibenausnehmung (12) korrespondierende Gehäuseausnehmung (11) des Gehäuses (2) die Deckscheibe (3) und das Gehäuse (2) miteinander verbindend unter Vorspannung eingefügt wird.

10. Verfahren zum Demontieren eines Anzeigeinstrumentes nach Anspruch 1, wobei eine Deckscheibe von einem Gehäuse getrennt wird und ein in einer Scheibenausnehmung (12) der Deckscheibe (3) und einer Gehäuseausnehmung (11) des Gehäuses (2) unter Vorspannung angeordnetes Verbindungselement (10) aus der Scheibenausnehmung (12) und/oder aus der Gehäuseausnehmung (11) eine Trennung von Gehäuse (2) und Deckscheibe (3) herbeiführend herausgedrückt wird, **dadurch gekennzeichnet, daß** das Verbindungselement (10) aus der Gehäuseausnehmung (11) und/oder aus der Scheibenausnehmung (12) mittels Druckluft herausgedrückt wird.

## Claims

1. Display instrument comprising a cover disk, a housing (2) retaining the cover disk (3) and a connector element (10) connecting the housing (2) and the cover disk (3), which connector element engages in a housing recess (11) arranged in the housing (2), wherein the connector element (10) is arranged in the housing recess (11) and a disk recess (12) of the cover disk (3) corresponding to the housing recess (11) under tension, **characterized in that** the housing (2) has a ventilation hole (16) connecting the housing recess (11) to a housing surface (15) facing away from the cover disk (3), and/or the cover disk (3) has a ventilation hole (17) connecting the disk recess (12) to a disk surface (18) facing away from the housing (2).

2. Display instrument according to Claim 1, **characterized in that** the housing recess (11) is constructed in the form of a housing slot (13) with a U-shaped cross section and/or the disk recess (12) as a disk slot (14) with a U-shaped cross section.

3. Display instrument according to one of Claims 1 and 2, **characterized in that** the housing recess (11) is arranged circumferentially in an edge region of the housing (2) and/or the disk recess (12) circumferentially in an edge region of the cover disk (3).

4. Display instrument according to one of the preceding claims, **characterized in that** the housing recess (11) and the disk recess (12) are axial recesses, which are aligned parallel with the direction of a joint between housing (2) and cover disk (3).

5. Display instrument according to one of the preceding claims, **characterized in that** the connector element (10) comprises a permanently elastic material.

6. Display instrument according to one of the preceding claims, **characterized in that** a ventilation channel (20, 24) is arranged on a floor of the housing recess (11) and/or on a floor of the disk recess (12).

7. Display instrument according to one of the preceding claims, **characterized in that** the housing recess (11) has a widened section (21) at its transition to the housing surface (25) and/or the disk recess (12) has a widened section (29) at its transition to the disk surface (26).

8. Method for production of a display instrument according to Claim 1, wherein a cover disk (3) is connected to a housing (2), and wherein successively at least a first partial area of a connector element (10) is introduced under tension into a housing recess (11) of the housing (2), the cover disk (3) and the housing (2) are placed together, a second partial area of the connector element (10) is introduced under tension into a disk recess (12) of the cover disk (3) corresponding to the housing recess (11) so as to connect the housing (2) and the cover disk (3) together, **characterized in that** the connector element (10) is sucked into the housing recess (11) and/or into the disk recess (12).

9. Method according to Claim 8, **characterized in that** initially at least a first partial area of a connector element (10) is introduced under tension into a disk recess (12) of the cover disk (3), then the cover disk (3) and the housing (2) are placed together, and thereafter a second partial area of the connector element (10) is introduced under tension into a housing recess (11) of the housing (2) corresponding to the disk recess (12) so as to connect the cover disk (3) and the housing (2) together.

10. Method for disassembly of a display instrument according to Claim 1, wherein a cover disk is separated from a housing and a connector element (10) arranged under tension in a disk recess (12) of the cover disk (3) and a housing recess (11) of the housing (2) is pressed out of the disk recess (12) and/or out of the housing recess (11) while bringing about a separation of housing (2) and cover disk (3), **characterized in that** the connector element (10) is pressed out of the housing recess (11) and/or out of the disk recess (12) using compressed air.

## Revendications

1. Instrument indicateur avec une vitre de fermeture, un boîtier (2) maintenant la vitre de fermeture (3) et un élément de jonction (10) raccordant le boîtier (2) et la vitre de fermeture (3) et venant s'engager dans une cavité de boîtier (11) disposée dans le boîtier (2), l'élément de jonction (10) étant disposé sous tension préalable dans la cavité de boîtier (11) et dans une cavité de vitre (12) de la vitre de fermeture (3), laquelle cavité de vitre correspond à la cavité de boîtier (11), **caractérisé en ce que** le boîtier (2) présente une ouverture de ventilation (16), laquelle relie la cavité de boîtier (11) avec une surface du boîtier (15) se trouvant à l'opposé de la vitre de fermeture (3) et/ou la vitre de fermeture (3) présente une ouverture de ventilation (17), laquelle relie la cavité de vitre (12) avec une surface de la vitre (18) se trouvant à l'opposé du boîtier (2).

2. Instrument indicateur selon la revendication 1, **caractérisé en ce que** la cavité de boîtier (11) est conçue sous la forme d'une rainure de boîtier (13) présentant une section transversale en forme de « U » et/ou la cavité de vitre (12) est conçue sous la forme d'une rainure de vitre (14) présentant une section transversale en forme de « U ».

3. Instrument indicateur selon l'une des revendications 1 et 2, **caractérisé en ce que** la cavité de boîtier (11) est disposée sur tout le pourtour, dans une zone de bordure du boîtier (2) et/ou la cavité de vitre (12) est disposée sur tout le pourtour, dans une zone de bordure de la vitre de fermeture (3).

4. Instrument indicateur selon l'une des revendications précédentes, **caractérisé en ce que** la cavité de boîtier (11) et la cavité de vitre (12) sont des cavités axiales qui sont orientées de manière parallèle à une direction d'assemblage du boîtier (2) et de la vitre de fermeture (3).

5. Instrument indicateur selon l'une des revendications précédentes, **caractérisé en ce que** l'élément de jonction (10) présente un matériau à élasticité permanente.

6. Instrument indicateur selon l'une des revendications précédentes, **caractérisé en ce qu'**un canal de ventilation (20, 24) est disposé au niveau d'une base de la cavité de boîtier (11) et/ou au niveau d'une base de la cavité de vitre (12).

7. Instrument indicateur selon l'une des revendications précédentes, **caractérisé en ce que** la cavité de boîtier (11) présente un élargissement (21, 29) au niveau de sa transition vers la surface du boîtier (25) et/ou la cavité de vitre (12) présente un élargissement (21, 29) au niveau de sa transition vers la surface de la vitre (26).

8. Procédé destiné à la fabrication d'un instrument indicateur selon la revendication 1, selon lequel une vitre de fermeture (3) est reliée à un boîtier (2) et selon lequel, de manière successive, tout au moins une première zone partielle d'un élément de jonction (10) est insérée sous tension préalable dans une cavité de boîtier (11) du boîtier (2), la vitre de fermeture (3) et le boîtier (2) sont mis en place bout à bout, une deuxième zone partielle de l'élément de jonction (10) est insérée, sous tension préalable et raccordant l'un à l'autre le boîtier (2) et la vitre de fermeture (3), dans une cavité de vitre (12) de la vitre de fermeture (3), laquelle cavité de vitre (12) correspond avec la cavité de boîtier (11), **caractérisé en ce que** l'élément de jonction (10) est aspiré dans la cavité de boîtier (11) et/ou dans la cavité de vitre (12).

9. Procédé selon la revendication 8, **caractérisé en ce que**, dans un premier temps, tout au moins une première zone partielle d'un élément de jonction (10) est insérée sous tension préalable dans une cavité de vitre (12) de la vitre de fermeture (3) et puis, dans un second temps, la vitre de fermeture (3) et le boîtier (2) sont mis en place bout à bout et ensuite, dans un troisième temps, une deuxième zone partielle de l'élément de jonction (10) est insérée, sous tension préalable et raccordant l'un à l'autre la vitre de fermeture (3) et le boîtier (2), dans une cavité de boîtier (11) du boîtier (2), laquelle cavité de boîtier correspond à la cavité de vitre (12).

10. Procédé destiné au démontage d'un instrument indicateur selon la revendication 1, dans lequel une vitre de fermeture est séparée par un boîtier et un élément de jonction (10), disposé sous tension préalable dans une cavité de vitre (12) de la vitre de fermeture (3) et dans une cavité de boîtier (11) du boîtier (2), est expulsé en dehors de la cavité de vitre (12) et/ou en dehors de la cavité de boîtier (11) en provoquant une séparation du boîtier (2) et de la vitre de fermeture (3), **caractérisé en ce que** l'élément de jonction (10) est expulsé en dehors de la cavité de boîtier (11) et/ou en dehors de la cavité de vitre (12) au moyen d'un air comprimé.
